(19) Europäisches Patentamt
European Patent Office
Office européen des brevets

(11) **EP 3 539 028 B1**

(12) **EUROPEAN PATENT SPECIFICATION**

(45) Date of publication and mention
of the grant of the patent:
**28.12.2022 Bulletin 2022/52**

(21) Application number: **17869137.4**

(22) Date of filing: **03.11.2017**

(51) International Patent Classification (IPC):
**G08B 29/18** *(2006.01)*        **G08B 21/16** *(2006.01)*

(52) Cooperative Patent Classification (CPC):
**G06N 7/00; G05B 13/04; G08B 21/16;
G08B 29/188;** G06F 30/00

(86) International application number:
**PCT/IB2017/056873**

(87) International publication number:
**WO 2018/087639 (17.05.2018 Gazette 2018/20)**

(54) **SYSTEMS AND METHODS FOR SUPERVISION OF LOCAL ANALYTICS**

SYSTEME UND VERFAHREN ZUR ÜBERWACHUNG DER LOKALEN ANALYSE

SYSTÈMES ET PROCÉDÉS DE SUPERVISION D'ANALYSES LOCALES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **10.11.2016   US 201662420137 P**

(43) Date of publication of application:
**18.09.2019   Bulletin 2019/38**

(73) Proprietor: **3M Innovative Properties Company**
St. Paul, MN 55133-3427 (US)

(72) Inventors:
• **BROOKS, Brian E.**
Saint Paul, Minnesota 55133-3427 (US)
• **BENOIT, Gilles J.**
Saint Paul, Minnesota 55133-3427 (US)

(74) Representative: **Vossius & Partner
Patentanwälte Rechtsanwälte mbB
Siebertstrasse 3
81675 München (DE)**

(56) References cited:
WO-A1-2016/011007     WO-A1-2016/011014
WO-A1-2016/039805     US-A1- 2007 033 925
US-A1- 2009 113 049     US-A1- 2011 248 857
US-A1- 2015 148 919     US-A1- 2016 004 980

EP 3 539 028 B1

## Description

## BACKGROUND

As the "Internet of Things" grows, more and more devices have sensors and processing power embedded in them. While this can offer intelligent operations (advanced criteria for alarms, indicators of part wear in devices, etc.), these embedded analytics are often slow to update, in part due to pre-programming of the models and basing the analytical methods and parameters off of pre-computed models. The models are often based on either first principles or "big data" driven aggregation of historical data; either of these approaches will contain imprecision due to assumptions, and in the case of aggregate data, the existence of third variables and directionality questions. These modeling approaches are also limited in their ability to recognize errors and self-correct, due to the lack of experimental control and the use of aggregate, passively collected data. Also, errors in these models can become increasingly costly or risky as they are applied to expensive capital equipment, for example for diagnosing maintenance needs in jet engines, or oil excavation equipment, faults on electrical grids, or when applied to safety issues, such as the use of remote sensors to guide decision-making around entering potentially hazardous sites such as methane leak sites.

Further, these models may not be frequently updated, often only being updated in new product generations, and tend to be general for the device; while some large installations may include tailoring to particular operational conditions or environments, there is insufficient scalability for updating and adapting the analytical modules, on many other devices with local analytics, including both selecting models and tuning their parameters. Automating the process may offer a more scalable way to tune local analytics for particular contexts or deployments.

Signal detection theory is a framework for analyzing the effectiveness of responding to particular signals, which has been used in air traffic controller evaluations, medicine, and forensic science. The framework breaks outcomes down into 4 categories, based on whether an action was taken, and whether the condition requiring the action was indeed present. Those categories are hits (where an action is taken and the condition is present), misses (where no action is taken, but the condition is present), false alarms (where action is taken but the condition is not present) and correct rejections (where action is not taken and the condition is not present). The four outcomes are all interrelated; for example, adjusting decision criteria to drive up the rate of hits necessarily also increases the incidence of false alarms for a given set of sensor characteristics (i.e. d-prime). From the distribution of those four outcomes, signal detection theory allows separate and independent values can be computed for both the sensitivity of the sensors and the accuracy of the response criteria, allowing for each element to be optimized. However, this optimization requires the separation of these two aspects of responding to signals to make it possible to isolate and optimize the response criteria; this is difficult if not impossible to achieve through analysis of historical data without an ability to control the confounds that affect these metrics, including their influence on one another when one cannot be known or controlled for.

Natural gas utilities often must monitor a critical point, for example when an emergency responder visits the site, evacuates it, and inspects it, using a hand-held methane detector while proceeding through the site until the levels reach an unsafe level, or when utility personnel must monitor capped well-heads, or monitoring low-level leaks to ensure they do not worsen. Electrical utilities must locate and characterize faults on their grids, and respond to those faults. In the emergency response example for gas utilities, he gas is typically then shut off remotely, and it is up to the unaided human judgment of the emergency responder to determine when to check a site. Should the emergency responder return to a site too early, this would expose them to the risk of explosion, and would count as a "false alarm" under signal detection theory, taking action when the event spurring the action (i.e. that gas levels had dropped below dangerous levels) has not actually occurred. However, the longer the responder waits, the longer the site is out of service, including leaving industrial sites idle or residents barred from entering their homes; this counts as a "miss" under signal detection theory, failing to recognize when an action should be taken. Remote sensors may offer some additional situational intelligence to support the emergency responder, but the behavior of gas within structures and its relationship to the overall safety to return to the leak site is not straightforward, requiring analytical tools evaluating the outputs of multiple sensors to provide an actionable recommendation that will increase the fraction of hits and correct rejections, maintaining responder safety while providing timely clearing of leak sites.

US 2015/0148919 A1 discloses a system and method for controlling a process such as an oil production process. The system comprises multiple intelligent agents for processing data received from a plurality sensors deployed in a job site of an oil well, and applies a probabilistic model for evaluating risk and recommending appropriate control action to the process.

WO 2016/011007 A1 discloses systems for implementing experimental trials on utility grids. Variations in grid parameters are selected to introduce into utility grids to improve the value of learning from each experimental trial and promoting improved utility grid performance by computing expected values for both learning and grid performance. Those trials are used to manage the opportunity costs and constraints that affect the introduction of variations into utility grid parameters and the generation of valid data that can be attributed to particular variations in utility grid parameters.

US 2009/0113049 A1 discloses a system for utilizing a neural network to make real-time predictions about the health, reliability, and performance of a monitored system. The system includes a data acquisition component, a power analytics server and a client terminal. The data acquisition component acquires real-time data output from the electrical system. The power analytics server is comprised of a virtual system modeling engine, an analytics engine, an adaptive prediction engine. The virtual system modeling engine generates predicted data output for the electrical system. The analytics engine monitors real-time data output and predicted data output of the electrical system. The adaptive prediction engine can be configured to forecast an aspect of the monitored system using a neural network algorithm.

## SUMMARY

According to the invention, a method and a system as recited in the independent claims are provided. The dependent claims define preferred embodiments. Methods for continuously updating and improving decision support provided by local analytics by: selecting specific models and/or model parameters for local analytics devices according to the likelihood that model will yield the proper ratio of hits, misses, false alarms and correct rejections based on the cost or benefit of each of those outcomes, responding to action triggers resulting from the models being applied by the local analytics devices, categorizing the outcomes of the response, in some cases through reference to other, yoked model selections for other local analytics devices in order to determine misses and correct rejections, and updating a database of models and outcomes used for selecting model parameters.

Systems for updating and improving local analytics criteria, which comprise a processor configured to determine a model for analytics, a response asset that may be activated by communications from a local analytics unit, and a database of models for analytics and their resulting outcomes, as well as a local analytics unit which comprises at least a model memory, one or more sensors, and a processor configured to determine the occurrence of an action trigger using the model in the model memory and the outputs of the one or more sensors.

## BRIEF DESCRIPTION OF THE DRAWINGS

**Figure 1** is a process flow diagram for an example method of the invention applied to updating local analytics.
**Figure 2** is a process flow diagram for an example method of the invention specifically directed to adjusting thresholds in remote gas monitoring systems.
**Figure 3** is a system diagram for an example system of local analytics modules.
**Figure 4** is a system diagram for an example system of remote gas sensors.

## DETAILED DESCRIPTION

Analytics evaluating sensor data, either at a local processor on a device, or acting on sensor data uploaded to the cloud, frequently triggers another event, which may confirm or refute the accuracy of the analytics determination by introducing additional resources beyond the sensor data being interpreted by the analytics. This allows local analytics determinations to be self-correcting and adaptive over time, both within and across devices by offering a feedback loop through which the local analytics determination may have its accuracy evaluated. For example, a device may trigger maintenance warnings at certain performance thresholds and/or runtime thresholds, or remote sensors may trigger a response to a condition, such as indicating that a natural gas leak site is now safe to visit and re-check; in all of these cases, the analytics model used may sometimes have false alarms or misses which may be costly or even dangerous.

Local analytics devices are devices with embedded sensors, processors, and communications which may be used to determine and respond to conditions at the device, including both internal device condition and events at or in proximity to the device. This may include measurements of run-time or parts wear indicating a need for maintenance, remote sensor applications providing information on state changes within (e.g. a set of remote methane sensors to provide ongoing monitoring of a leak site). The responses or actions triggered by the local analytics devices may be from external actors or devices in communication with the local analytics device (i.e. performing maintenance or having an asset visit and inspect a monitored leak site) or may be performed by the device itself, for example a capacitor bank automatically switching on based on local determination of power factor based on voltage and current measurements at or near the device.

Local analytics devices interpret the sensor outputs using a processor by using a model to link the sensor outputs with particular events and action triggers (i.e. when a value indicates that maintenance or replacement is required, or when it is likely that a gas leak has been stopped, or if the leak has become more severe) in order to identify and respond to the occurrence of particular conditions or events requiring response. The models may include, for example, threshold values for certain sensor readings such as a runtime after which a maintenance is to be performed, may be based on relationships among sensor readings, such as differences among readings from multiple gas sensors and comparisons being used to determine changes in state of the leak site, based on ranges such as having particular ranges of power quality within which a capacitor will be switched from off to on or vice versa, or other functions for event detection or action triggering based on the sensor outputs and model parameters. Model parameters include the function used to interpret the sensor results and values such as particular thresholds and ranges used in those interpretations.

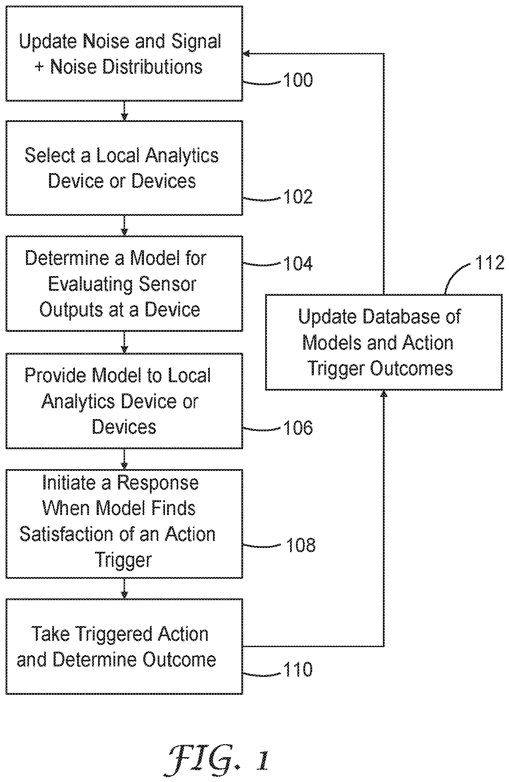

A method for dynamically adjusting the analytics criteria for a local device is depicted in Fig. 1. The method begins with updating noise and signal plus noise distributions for local analytics in step **100,** and the selecting a local analytics device or set of devices in step **102.** A model for evaluating sensor outputs at the selected device or set of devices is determined in step **104,** based on a database of models and resulting outcomes of actions triggered using those models. The determined model is provided to the local analytics device in step **106,** and is used to evaluate incoming sensor data at the device, including initiating a response when an action trigger included in the model is satisfied, in step **108.** The satisfaction of the action trigger in step **108** drives the action taken in step **110,** which also includes a determination of whether the action trigger provided a hit, a miss, a false alarm or a correct rejection. This outcome captured in step **110** is then added to a database of models and action trigger outcomes in step **112,** which is used in subsequent determinations of models for local analytics in later iterations of step **104.**

Noise distributions and signal plus noise distributions are updated in step **100,** based on outcome data, and are used to compute a current value for beta-optimal. Beta-optimal indicates the desired decision criteria according to signal detection theory, resulting in an optimal distribution of hits (where a condition is successfully detected and responded to), misses (where a condition exists but is not detected), false alarms (where a response is triggered, but the condition does not actually exist) and correct rejections (where the condition does not exist, and no response is triggered) given the relationships among those outcomes. It is computed from a value assigned to each outcome, and a sensitivity value for the sensors which is referred to in signal detection theory as d-prime. D-prime may account for not only the precision of the sensors themselves, but the sensitivity of a particular configuration of the sensors or a deployment protocol which is followed in placing the sensors. The d-prime value may be known for a given set of sensors used in a local analytics device, and that known value input via a user interface or retrieved from a memory for use in the computation of the beta-optimal value. The beta-optimal value may be specific to an individual local analytics device or general to a class of local analytics devices having similar sensing characteristics, operational contexts and/or value or consequences of each outcome. Beta-optimal is computed based on the relative value of each outcome and data on the previous distribution of outcomes according to signal detection theory, for example by: determining the noise distribution p(N) by computing the number of false alarms and correct rejections divided by the total number of outcomes, determining the signal-plus-noise distribution p(SN) by computing 1-p(N), and computing beta optimal by dividing p(N) by p(SN) and multiplying that value by (V(CR)-C(FA))/(V(H)-C(M)) where V(CR) is the value of a correct rejection, C(FA) is the cost of a false alarm, V(H) is the value of a hit, and C(M) is the cost of a miss. Beta-optimal is re-calculated across iterations of this method as additional data on outcomes is generated, and is updated as data regarding the values and costs for outcomes change over time.

Selecting a local analytics device or devices in step **102** is performed by identifying one or more of the local analytics devices for which the model used in performing local analytics is to be determined. This selection may be based on deployment of the local analytics device (i.e. placing remote methane sensors at a gas leak site), the completion of a prior iteration of the method at a local analytics device or devices (i.e. when a device is receiving maintenance following a request based on local analytics under a previous model), or based on a schedule.

Determining a model for evaluating sensor outputs at a device is performed in step **104.** The model is determined by selecting a model from a set of models. The models are methods for determining the condition of a site or device based on sensor inputs such as algorithms, formulae, mathematical or statistical models which may be executed by a processor at a local analytics device selected in step **102.** The set of models from which the model to be used is selected are all directed towards making the same determination of site or device conditions, for example identifying when a device needs maintenance or when a site where there has been a methane leak has experienced a change in state relative to gas concentrations. The models may differ in methodology (for example, using pure runtime to determine maintenance need or requiring a certain threshold level of change in key performance metrics to determine that maintenance need) and/or in parameters (for example, each model using different weighting or scaling factors, delay periods, or threshold values). Each model is associated with a set of outcomes (hits, misses, correct rejections and false alarms) from previous iterations of this method. That set of outcomes is used to compute a d-prime value which characterizes the sensitivity of the model and establishes confidence intervals around the beta value based on the sample size (i.e. total number of logged outcomes). Model selection may be performed based on the d-prime values, confidence intervals, and their overlap with one another, to select among models most likely to have the highest sensitivity. This selection may, for example, be done through computing a likelihood that each model would have the highest value for d-prime. From that computed likelihood of highest d-prime the model is selected based on constrained randomization wherein the probability of selecting a model is determined by its likelihood of having the highest d-prime. For example, if Model 1 is 70% likely to have the highest d-prime based on the overlap of confidence intervals, Model 2 is 20% likely to have the highest d-prime, Model 3 is 0% likely to have the highest d-prime, and Model 4 is 10% likely to have the highest d-prime, the randomization will be weighted to match that, such that there is a 70% chance of selecting Model 1, a 20% chance of selecting Model 2, a 0% chance of selecting Model 3, and a 10% chance of selecting Model 4 as the determined threshold value for the sensor deployment.

In some embodiments, the model assigned to the local analytics device in step **106** may also be paired with one or more yoked controls to further enhance the ability to link models with particular outcomes (in situations where a response has not yet been made), providing the correct rejection and miss determinations which required to compute ROC curves and perform signal detection analyses. Yoked controls may be associated with one another by determining stochastic equivalence among the deployments of local analytics models and associating two or more stochastically equivalent deployments of local analytics models with one another. Stochastic equivalence among yoked controls enables the determination of group means for outcomes in an unbiased fashion, by ensuring significant, if not complete, overlap among the probabilities of the possible outcomes. This overlap in probabilities is based on the similarity of the situations and likely probability distributions of outcomes for those assignments of local analytics models to local analytics devices which may then be yoked together. Stochastic equivalence may be determined, for example, by considering all of a particular model or class of local analytics devices to be equivalent, considering particular deployment protocols for the local analytics device (i.e. placement of methane sensors at a gas leak site according to particular rules or heuristics), or, for example, based on similarity scores computed for the particular deployments of local analytics devices based on characteristics surrounding them (for example, for measuring wear on oil pumps, the viscosity and presence of particulate matter in the pumped oil may be used to compute which pumps may be sufficiently equivalent for pairing as yoked controls). Once determined, these associations may be stored in a database, for example as a field accompanying each assignment of a local analytics model to a local analytics device.

Providing a model to a local analytics device or devices is performed in step **106**. The model determined in step **104** is provided to the local analytics device, by wired or wireless communications such as Ethernet protocols, WIFI communications (e.g. 802.11 standards), the BLUETOOTH technology, the ZIGBEE products, or other such communications enabling the data of the model to be communicated to the local analytics device or devices. When received by the local analytics device or devices, the model is may stored in a memory, to be used by a processor to determine when action triggers in the model have been satisfied by sensor readings at the local analytics device or devices.

Initiating a response when the model finds satisfaction of an action trigger occurs in step **108**. A processor at the local analytics device receives the outputs of sensors at or near the local analytics device and using the model determined in step **104** and provided to the device in step **106,** and when the sensor outputs satisfy triggers set in the model, the response is initiated by taking the action defined by the trigger in the model. This initiation of response may be communicating a request or change of state (i.e. indicating a change in conditions at a leak site and requesting personnel to examine the site) or in some embodiments, may be initiating an automated action such as sending a signal within the local analytics device to drive the switching of a capacitor bank from an off state to an on state or vice versa.

Taking the triggered action and recording an outcome occurs in step **110.** In embodiments where the initiation of step **108** is a communication, step **110** is performed by taking the action requested by the communication, for example dispatching a maintenance crew to the local analytics device and performing maintenance, or visiting a gas leak site to investigate following a communication indicating a change of state. In these embodiments, the outcome of the local analytics device determination is measured during the response to the communication, for example the personnel performing maintenance record whether the maintenance was required or not. These determinations are recorded, and are used in step **112** to determine whether the model in this iteration of the process produced a hit, a miss, a correct rejection and/or a false alarm in triggering the response based on sensor outputs. In embodiments where the initiation of step **108** is the initiation of an automated action, step **110** is performed by completing that particular action, such as completing the physical switching of the state of a capacitor bank. In these embodiments, sensors outside the local analytics device may be used to determine the occurrence of a hit, miss, false alarm or correct rejection, for example for a capacitor bank switch, determining whether power factor has moved closer to or further from unity following the switching of that capacitor bank.

In some embodiments, determinations of misses and correct rejections may be determined during or after the outcome determination of step **110** by referencing the outcome of one or more yoked trials associated with the model during step **106.** This determination is made by identifying whether the associated yoked trials are a higher or lower standard for the action trigger. Whether the standard is higher or lower may be determined by comparing the rate of triggering action responses for the yoked trial model to the rate of triggering action responses for the model, with a higher rate of action responses indicating a lower standard and a lower rate of action responses indicating a higher standard.

When the outcome determined by the action response is a "hit," if a yoked trial that has a lower standard also yields a hit, the outcome determination may be changed to a "miss", in that the condition may have been able to be detected and responded to earlier, according to the yoked trial with a lower standard providing a hit. When a lower standard yoked trial yields a false alarm, a "hit" remains a "hit." Where the outcome determined by the action response is a "hit," and a yoked trial with a lower standard yields a "false alarm," the outcome determination may additionally be labeled a "correct rejection." In some examples, outside data may also be used to supplement the determination of misses and correct rejections. For example, if an incident occurs (and this incident is detected and logged through another system interfacing with a system performing this example method, or entered via a user interface) without the local analytics unit having detected it and triggering a response, that data may be used to define the performance of the assigned local analytics model as a "miss."

Updating the database of models and action trigger outcomes is performed in step **112.** Once the outcome of a hit, miss, false alarm or correct rejection for the model is determined, the outcome is added to the database, adding that result to a set of results for the model which was selected in step **104** and further refining the understanding of the relative frequencies of hits, misses, false alarms and correct rejections when that model is applied at local analytics device. The updated database may then be referenced in subsequent iterations of this method, at step **104** for determining model parameters and/or selecting a model for a local analytics device.

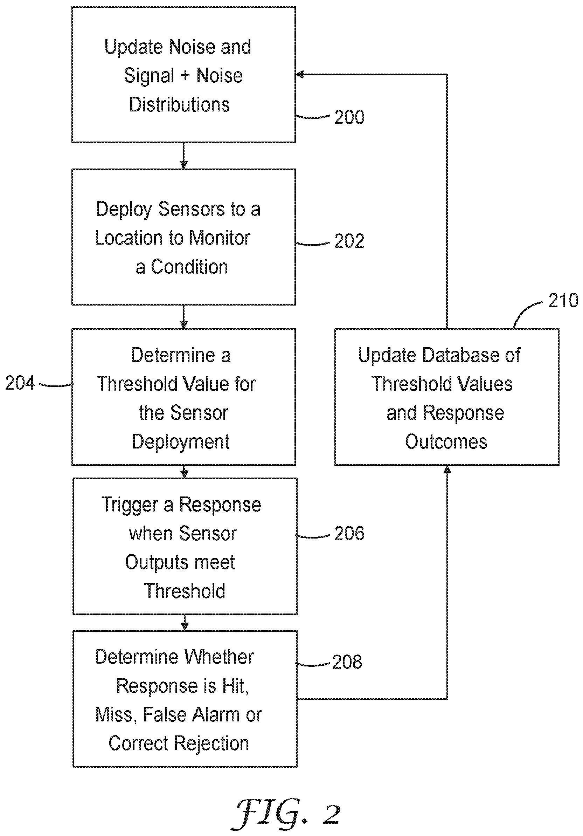

One particular example method relating to adjusting response criteria in remote gas sensors is depicted in Fig. 2. In this example, a plurality of sensors are left at a leak site for a gas such as methane, and the readings from the multiple sensors are evaluated to determine when the site may be re-checked, based on a high likelihood of site safety. In this example method, the beta-optimal for determining leak site condition is computed in step **200.** Sensors are deployed to monitor a site condition in step **202,** and a threshold value for the sensors is determined in step **204;** these steps may be in the order presented, or may be concurrent or the order reversed, with threshold values determined prior to sensor deployment, depending on the condition and operational context. Once the threshold is determined and the sensors deployed to a site, the sensors monitor the site, and during this monitoring, the threshold is triggered in step **206.** Once the threshold is met, the site is re-evaluated and that in that re-evaluation, it is determined whether the triggering of the threshold was a hit, miss, false alarm or correct rejection in step **208.** The outcome determined in step **208** is then added to a database of thresholds and response outcomes in step **210,** which may be used in subsequent determinations of threshold values according to step **204** in later iterations of this method.

Noise and signal plus noise distributions for the gas sensing models are computed in step **200.** The beta-optimal is computed from these distributions in addition to data on the relative costs and/or benefits of a particular outcome in the context of returning to a gas leak site, for example a large cost for a return to a site where there is still a dangerous level of gas, a small cost for missing an opportunity to return to and clear a site sooner, and benefits to correctly identifying that a site is not suitable to return to currently and to identifying promptly when a site can be re-entered and cleared. The cost and/or benefit data may be user-determined or derived from other data such as financial or risk models. Beta-optimal is computed as described above in step **100,** using the value of each outcome, and may be computed for each iteration of this process.

Deploying sensors to a location is performed in step **202.** One or more remote gas sensor units, for example methane sensors, are deployed to the leak location in accordance with a deployment protocol, to the extent possible according to the protocol and the permissible levels of gas compared to quantities that may trigger an evacuation. A deployment protocol may indicate the number of sensors to be deployed and locations to place the sensors, based on, for example, particular rooms to place sensors in, or the heights at which sensors should be placed. Once the sensors are deployed, in some embodiments the deployment and the extent to which it was performed may be confirmed, for example through utility maintenance personnel interacting with a user interface to confirm the number of sensors placed and whether they were placed as defined in the deployment protocol.

Determination of a threshold value or values for the sensors is performed in step **204.** The threshold value corresponds to when sensor readings may be indicative of a change in state, for example dissipation of gas following shutoff of gas flow to the leak site. The threshold value may be in terms of relationships among sensor outputs, relationships of sensor values to initial and/or peak measured values, or absolute levels of a sensed gas such as methane. The threshold value may be determined from a set of potential values which may be user-determined or procedurally generated based on permissible ranges and boundaries set by users and/or data from previous iterations of methods of the invention. Each threshold value has an associated beta value computed from the distribution of hits, misses, correct rejections and false alarms which occurred in previous iterations of the method and which are stored in a database of thresholds and outcomes. These beta values have confidence intervals around them, which may be computed based on the current sample size (the total number of data points, i.e. the sum of the totals of hits, misses, correct rejections and false alarms). For one or more threshold values, the overlap of the confidence intervals around each d-prime value may be used to determine a likelihood that a particular threshold value will provide the best sensitivity. From that likelihood, the threshold value may be determined through weighted randomization based on the likelihood that the threshold value is the best option. For example, if Threshold Value 1 is 70% likely to have the highest d-prime, Threshold Value 2 is 20% likely to have the highest d-prime,, Threshold Value 3 is 0% likely to have the highest d-prime,, and Threshold Value 4 is 10% likely to have the highest d-prime,, the randomization will be weighted to match that, such that there is a 70% chance of selecting Threshold Value 1, a 20% chance of selecting Threshold Value 2, a 0% chance of selecting Threshold Value 3, and a 10% chance of selecting Threshold Value 4 as the determined threshold value to be used with the sensor deployment.

In some embodiments, the determination of the threshold value in step **204** is based on the deployment of the sensors in step **202**. In these embodiments, the particular deployment and in some embodiments the extent the deployment was completed may be used to reference a database and retrieve a d-prime value and/or access historical outcome data for the particular deployment, for use in determining the threshold value in step **204**. In some embodiments, the threshold value may be determined prior to or concurrent with the deployment of the sensors in step **202,** using set values determined by the sensors, the type of deployment location, or an assumption that a particular protocol is used and fully implemented.

A response is triggered when the threshold value is satisfied in step **206**. The remote gas sensors measure and regularly or continuously report their results, which are compared to the threshold determined in step **204** at a unit located at or near the remote gas sensors and in communication with those gas sensors, for example by wireless communications such as the ZIGBEE products, WIFI communications (802.11 protocols). When the most recently received sensor outputs are determined by a processor to satisfy the threshold, indicating a change in state at the leak site (i.e. levels dropping indicating successful gas shutoff and a need to re-check and clear the leak site), a message is sent via a communications link, for example wireless communications such as the ZIGBEE products, WIFI communications, the BLUETOOTH technology or cellular communications (i.e. 3G, 4G LTE) to a response asset; the response asset may be, for example, a mobile device carried by emergency response personnel such as the personnel who initially responded to the leak site and deployed the sensors in step **202**.

Whether the response is a hit, miss, false alarm or a correct rejection is determined in step **208**. When the response asset visits the leak site in accordance with the action trigger of step **206,** the response asset independently measures gas levels at the site, for example using a hand-held methane sensor, and indicates whether the site was indeed safe to return; this may be done, for example, through a user interface on a device, such as an extension of the user interface used to confirm deployment protocols in some embodiments of step **202**. In addition to this data from an individual visit, data from yoked trial associated with the current response may be used to identify correct rejections and misses.

Updating a database of threshold values and response outcomes is performed in step **210** by taking the outcome or outcomes determined in step **208,** associating the outcome with the selected threshold value, and adding the associated outcome and threshold value to a database, which may optionally also include the deployment protocol for which the threshold value was selected. This database is used in determining the threshold values in step **204**.

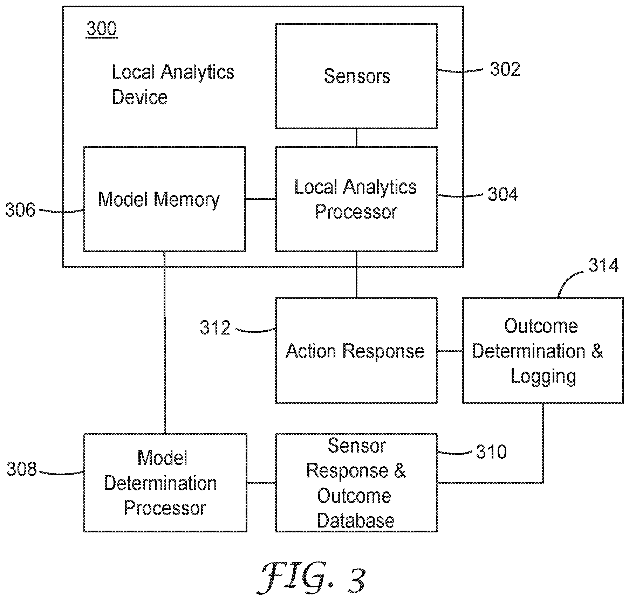

An example system with local analytics units that are dynamically updated to optimize model selection is depicted in Fig. 3. The system includes local analytics units **300,** whose components include sensors **302,** a local analytics processor **304** and a model memory **306**. The local analytics device is connected communicatively to a model determination processor **308,** and the local analytics processor **304** triggers an action response unit **312**. The action response **312** interacts with outcome determination and logging **314** to characterize the local analytics triggered response by the action response **312** as a hit, miss, correct rejection or false alarm, and the outcome determination and logging **314** provides this information to a memory configured to store a sensor response and outcome database **310**. The processors and memories may be located together and coupled directly (e.g. wired together) or coupled only communicatively in a cloud architecture, transmitting the data among the elements via the Internet or other remote communications.

The local analytics unit **300** is a device which includes sensors **302,** a local analytics processor **304** and model memory **306,** using the sensors, processors and memories to evaluate conditions at the local analytics unit **300**. The local analytics unit may be part of another device (for example, the sensors, processors and memories may be connected to parts of a pump, turbine, or engine) or may be the entire local analytics unit (for example, for a monitoring system for a gas leak site). The components of the local analytics unit are communicatively coupled to one another through wired or wireless means, but do not need to share a housing, and may be in proximity to one another (with the communicative coupling done wirelessly, for example through cellular, WIFI communications, the BLUETOOTH technology or the ZIGBEE products) or directly connected. The local analytics unit **300** may include wired or wireless communications to an action response **312** which triggers a response under certain conditions such as when a device including the local analytics unit **300** needs maintenance, detects and in some examples characterizes a fault needing mitigation or resolution, or reports on a change in the state of a location such as a gas leak site becoming safe to enter.

The local analytics unit **300** includes sensors **302**. The sensors may be, for example, counters for runtime, piezoelectric monitors of stress cycles, gas sensors such as methane sensors, current, voltage and/or other sensors for identifying and characterizing electrical faults, environmental sensors such as temperature sensors, pressure sensors for pipeline monitoring, or other sensors which provide information about a condition that may be responded to by an action response **312**. The sensors produce outputs which may be raw electrical signals or which may be converted to digital values, and which are provided to the local analytics processor **304**.

The local analytics unit **300** also includes a local analytics processor **304,** configured to receive the sensor outputs and, using a model stored in model memory **306,** determine a condition at or near the local analytics unit through interpretation of the sensor outputs. The local analytics processor may be a microprocessor of any standard, commercially available variety, and may be selected based on power consumption qualities or built into a microcontroller which may also include the model memory **306,** inputs from the sensors **302** and an output to a communication antenna such as WIFI communications, the ZIGBEE products, the BLUETOOTH technology or cellular (i.e. 3G or 4G LTE).

The local analytics unit **300** also includes a model memory **306** configured to store a model for use in interpreting the outputs of sensors **302** by the local analytics processor **304**. The model memory **306** may be a non-volatile memory such as flash memory or a hard disk drive. In some embodiments, the model memory **306** is coupled to a communications unit such as a cellular, WIFI communications, the BLUETOOTH technology or the ZIGBEE products antenna from which it received model data which is then stored in the model memory **306**.

A model determination processor **308** is configured to set the parameters of a model which is provided to the local analytics processor **304** of the local analytics unit. The model determination processor is a processor configured to receive information from a database of local analytics models and their prior outcomes, and select a model to assign to a local analytics device **300**. The determination may be made by computing the likelihood that a model is the best available model for use by the local analytics device from the hits, misses, false alarms and correct rejections for each potential model, for example by computing a beta value for the particular model and confidence intervals around it based on sample size and the distribution of outcomes and comparing those values to a determined optimal beta value. Using the computed likelihood for one or more models, a model may be selected, for example by using weighted randomization wherein the weighting for each model is determined based on those computed likelihoods.

A sensor response and outcome database **310** is a memory configured to store a database of the outcomes that result from using each model selected by the model determination processor **308** to evaluate output from sensors **302** at the local analytics processor **304**. The information from this memory is used by the model determination processor **308** when determining the model to provide to the local analytics unit **300**. The sensor response and outcome database may be stored on non-volatile memory such as one or more hard disk drives or flash memory.

Action response **312** is a unit or personnel which is separate from the local analytics device **300** but that respond to determinations by the local analytics processor **304** or has its actions queued in accordance with the outputs of the local analytics processor **304**. Examples include an emergency response crews, such as gas distribution network emergency responders, or maintenance personnel on-call or queued to visit, inspect and maintain devices which automatically report wear states and maintenance needs.

An outcome determination and logging unit **314** characterizes the situation reported by the local analytics processor **304** based on the findings of the action response **312**. This may be input through a user interface, based on output of sensors carried by the action response personnel or assets, or from other remote sensors near or at the local analytics unit, but separate from the sensors **302** and whose outputs are not considered by the local analytics processor **304**. The outcomes determined and logged by this unit are added to the sensor response and outcome database 310.

In some examples, the outcome determination performed by the unit may include reference to associated yoked trials, using the outcomes across two or more associated yoked trials to allow the determination of correct rejections and misses to provide the complete set of information required to determine the accuracy of local analytics models.

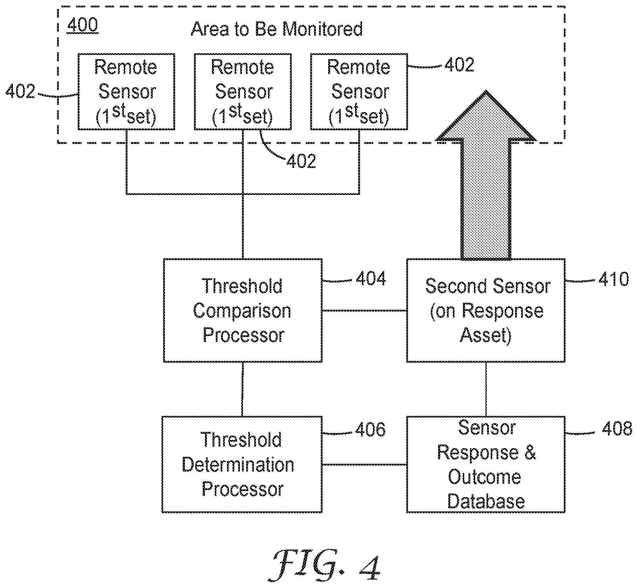

A particular example system where the local analytics unit is a set of remote gas sensors used to monitor a condition and trigger a re-entry and assessment of a leak site is depicted in Fig. 4. Sensors **402** are deployed in a monitoring site **400**. The output of the sensors **402** is evaluated by a threshold comparison processor **404,** which receives threshold values from a threshold determination processor **406,** and the threshold comparison processor **404** directs a response asset including a second sensor **410** to enter the monitoring site **400**. The second sensor **410** on the response asset communicates with a sensor response and outcome database **408** to provide feedback on site conditions and whether the conditions encountered by the response asset indicate a hit, miss, false alarm or correct rejection by the sensors **402** and the threshold comparison processor **404,** and that result is stored with the associated threshold value in the sensor response and outcome database **408.**

Leak site **400** is an area in which there may be a gas (typically methane, but may be other hazardous gases as well) leak, and the site will be monitored. The leak site may be identified by, for example, utility customers calling in when they smell the odor of natural gas. The leak site is a location where there may be a methane leak, such as a capped well head, a house from which a leak has been called in, and may include land surrounding structures as well as the structures themselves, or even include adjacent structures depending on the nature and severity of the possible leak and the timing of the response to that possible leak.

Sensors **402** are deployed to the leak site. The sensors may be gas sensors such as methane sensors or other hazardous gas sensors. The sensors **402** may be intrinsically safe, and may be any configuration or variety of methane sensor such as flame ionization, acoustic, or infrared. The sensors may be one or more remote sensors which are communicatively coupled through wired or wireless means (for example, the ZIGBEE products, WIFI communications, or cellular data such as 3G or 4G LTE connections) to one another and/or to a base station, all of which may be deployed to the leak site **400.**

Threshold comparison processor **404** is configured to receive readings from sensors **402** and determine whether the sensor readings satisfy a threshold provided by the threshold determination processor **406** and stored in a memory coupled to the threshold comparison processor **404**. The threshold may be, for example, a threshold value for any of the sensors **402,** may be based on a threshold value for the reading of each of the sensors **402,** or may be based on relationships among specific sensor **402** outputs given the deployment of those sensors according to a particular protocol (for example, comparing a sensor placed approximately 4 feet off the floor of the leak site **400** vs. another sensor placed 8 feet above the floor of the leak site **400**).

Threshold determination processor **406** is a processor configured to set a threshold value which is used to evaluate the output of sensors **402** to determine a change in state of the leak site **400**. The determined threshold may be in terms of, for example, methane levels at individual sensors **402** or relationships among methane levels at different sensors **402** deployed to the leak site **400**. The determination is made in part based on data from sensor and response outcome database **408**, for example confidence intervals computed around the measured beta value (based on relative rates of hits, misses, false alarms and correct rejections in previous trials using that threshold) for each potential threshold to be selected from, and the overlap of those confidence intervals with a computed optimal value for beta.

Sensor response and outcome database **408** is a memory configured to store data relating to thresholds for detecting changes in state of leak site **400** based on the prior outputs of the threshold comparison processor **404** and the outcomes of those trials. Optionally, the database may include values assigned to each outcome (hit, miss, correct rejection, and false alarm) for the purpose of identifying the optimal beta value for threshold values used for making determinations of site condition. Optionally, the database may also include an association between a first threshold value and one or more other threshold values involved in a yoked trial, enabling outcomes for each threshold value to be used to determine the existence of misses and correct rejections for those particular yoked trials.

Second sensor **410** is a methane detector. The sensor may be integral with a response asset or a handheld sensor unit carried by response personnel. The sensor is separate from the remote sensor or networks of sensors **402**. Second sensor **410** is used to measure the methane level at leak site **400** when it is visited by a response asset such as emergency first responders to a gas site. The reading taken by second sensor **410** may be added to the sensor response and outcome database **408** directly, or an outcome determined based on the output of second sensor **410** may be entered manually (by, for example, the emergency first responder's determination confirming that the site was suitable for re-entry or that the site was unsuitable for re-entry) through a user interface providing the outcome to the threshold and outcome database **408**, or the results from the second sensor **410** may be provided to a processor which determines an outcome based on the sensor outputs and provides the outcome determination to the threshold and outcome database **408**.

**Claims**

1. A method for updating an analytics model used with a device, comprising:

    determining a local analytics model comprising an action trigger, based on a database (310; 408) of local analytics models and model response outcomes;
    providing the local analytics model to a local analytics device (300; 402, 410);
    initiating a response when sensor outputs at the local analytics device (300; 402, 410) satisfy the action trigger;
    determining an action trigger outcome based on conditions at the local analytics device (300; 402, 410) measured during the initiated response;
    updating the database (310; 408) of local analytics and model response outcomes with the action trigger outcome;
    **characterised by** further comprising:
    computing a beta optimal value for the local analytics device (300; 402, 410) using noise distributions and signal plus noise distributions updated based on outcome data.

2. The method of claim 1, wherein computing the beta optimal value comprises:

    determining a noise distribution p(N) by computing a number of false alarms and correct rejections divided by a total number of outcomes;
    determining a signal-plus-noise distribution p(SN) by computing 1-p(N), and
    computing the beta optimal value as

$$(p(N) \, / \, p(SN)) \times (V(CR)\text{-}C(FA))/(V(H)\text{-}C(M))$$

    where V(CR) is a value of a correct rejection, C(FA) is a cost of a false alarm, V(H) is a value of a hit, and C(M) is a cost of a miss.

3. The method of any preceding claim 1 to claim 2, wherein determining a local analytics model comprises weighted randomization based on an overlap in confidence intervals for d-prime of each of a plurality of local models, where d-prime denotes a sensitivity value for sensors.

4. The method of any preceding claim 1 to claim 3, wherein determining the local analytics model comprises:

   selecting one or more yoked trials; and
   associating the one or more yoked trials with the determined local analytics model.

5. The method of claim 4, wherein determining the action trigger outcome comprises:

   receiving outcome data for associated yoked trials; and
   comparing the outcome data for associated yoked trials to the outcome of the action response.

6. A method for evaluating a gas leak site, comprising:

   deploying a plurality of remote methane sensing units (402) to a site (400);
   receiving sensor outputs from the plurality of remote methane sensing units (402);
   performing the method of any one of the preceding claims, wherein

      determining a local analytics model comprises selecting parameters for a model for converting methane sensor outputs to an assessment of site condition based on a database (408) of model parameters and accuracy of determinations of changes in site condition;
      determining an action trigger outcome comprises determining a change in site condition based on the sensor outputs and the model revisiting the site based on the change in site condition; and
      updating the database of local analytics and model response outcomes comprises updating the database (408) of model parameters and accuracy of determinations of changes in site condition based on the revisiting of the site.

7. The method of claim 6, wherein selecting parameters for a model comprises weighted randomization based on an overlap in confidence intervals for the accuracy of determinations of changes in site condition.

8. The method of any preceding claim 6 to claim 7, wherein selecting parameters for a model is performed according to yoked control experimental design.

9. The method of any preceding claim 6 to claim 8, wherein revisiting the site further comprises measuring methane levels at the site.

10. The method of any preceding claim 6 to claim 9, wherein the accuracy of a determination of change in site condition is classified as a hit, miss, false alarm or correct rejection.

11. A system for using an analytical model to evaluate a situation, comprising:

    a local analytics device (300; 402) comprising one or more sensors (302; 402), a model memory, and a local analytics processor (304) configured to evaluate the outputs of the one or more sensors (302; 402) based on a model stored in the model memory;
    a model determination processor (308) configured to determine a local analytics model;
    a memory configured to store a database (310; 408) of local analytics models and outcomes;
    a response asset triggered by the local analytics processor;
    **characterised in that** the model determination processor (308) is configured to determine a beta optimal value for the local analytics device (300; 402) using noise distributions and signal plus noise distributions updated based on outcome data.

12. The system of claim 11, wherein the processor configured to determine a beta optimal value is configured to

    determine a noise distribution p(N) by computing a number of false alarms and correct rejections divided by a total number of outcomes;
    determine a signal-plus-noise distribution p(SN) by computing 1-p(N); and compute the beta optimal value as

$$(p(N) / p(SN)) \times (V(CR)-C(FA))/(V(H)-C(M))$$

where V(CR) is a value of a correct rejection, C(FA) is a cost of a false alarm, V(H) is a value of a hit, and C(M) is a cost of a miss.

**13.** The system of any preceding claim 11 to claim 12, further comprising an interface for inputting an outcome of a determination by the local analytics processor (304).

**14.** The system of any preceding claim 11 to claim 13, wherein the response asset comprises a sensor (410).

**15.** The system of any preceding claim 11 to claim 14, wherein the model determination processor (308) configured to determine a local analytics model determines the local analytics model based on weighted randomization of local analytics models based on an overlap between confidence intervals for their beta value and the beta optimal value.


**Patentansprüche**

**1.** Ein Verfahren zum Aktualisieren eines Analysemodells, das mit einer Vorrichtung verwendet wird, aufweisend:

Ermitteln eines lokalen Analysemodells, das einen Aktionsauslöser aufweist, basierend auf einer Datenbank (310; 408) von lokalen Analysemodellen und Modellreaktionsergebnissen;
Bereitstellen des lokalen Analysemodells für eine lokale Analysevorrichtung (300; 402, 410);
Initiieren einer Reaktion, wenn Sensorausgaben an der lokalen Analysevorrichtung (300; 402, 410) den Aktionsauslöser erfüllen;
Ermitteln eines Aktionsauslöserergebnisses basierend auf während der initiierten Reaktion an der lokalen Analysevorrichtung (300; 402, 410) gemessenen Bedingungen;
Aktualisieren der Datenbank (310; 408) von Ergebnissen lokaler Analysen und Modellreaktionen mit dem Aktionsauslöserergebnis; **dadurch gekennzeichnet, dass** es ferner aufweist:
Berechnen eines optimalen Beta-Wertes für die lokale Analysevorrichtung (300; 402, 410) unter Verwendung von Rauschverteilungen und Signal-plus-Rauschverteilungen, die basierend auf Ergebnisdaten aktualisiert wurden.

**2.** Das Verfahren nach Anspruch 1, wobei das Berechnen des optimalen Beta-Wertes aufweist:

Ermitteln einer Rauschverteilung p(N) durch Berechnen einer Anzahl von Fehlalarmen und korrekten Zurückweisungen, geteilt durch eine Gesamtzahl von Ergebnissen;
Ermitteln einer Signal-plus-Rauschverteilung p(SN) durch Berechnen von 1-p(N) und Berechnen des optimalen Beta-Wertes als

$$(p(N)/p(SN)) \times (V(CR)-C(FA))/(V(H)-C(M))$$

wobei V(CR) ein Wert einer korrekten Zurückweisung ist, C(FA) Kosten eines Fehlalarms sind, V(H) ein Wert eines Treffers ist und C(M) Kosten eines Fehlschlags sind.

**3.** Das Verfahren nach einem vorstehenden Anspruch 1 bis Anspruch 2, wobei das Ermitteln eines lokalen Analysemodells eine gewichtete Randomisierung basierend auf einer Überlappung von Konfidenzintervallen für d-prime eines jeden einer Mehrzahl von lokalen Modellen aufweist, wobei d-prime einen Empfindlichkeitswert für Sensoren bezeichnet.

**4.** Das Verfahren nach einem vorstehenden Anspruch 1 bis Anspruch 3, wobei das Ermitteln des lokalen Analysemodells aufweist:

Auswählen eines oder mehrerer zusammengefasster Versuche; und
Zuordnen des einen oder der mehreren zusammengefassten Versuche zu dem ermittelten lokalen Analysemodell.

**5.** Das Verfahren nach Anspruch 4, wobei das Ermitteln des Aktionsauslöserergebnisses aufweist:

Empfangen von Ergebnisdaten für zugeordnete zusammengefasste Versuche; und
Vergleichen der Ergebnisdaten für zugeordnete zusammengefasste Versuche mit dem Ergebnis der Aktionsreaktion.

**6.** Ein Verfahren zum Bewerten einer Gasleckstelle, aufweisend:

Aufstellen einer Mehrzahl von Methan-Fernerfassungseinheiten (402) an einem Standort (400);
Empfangen von Sensorausgaben von der Mehrzahl von Methan-Fernerfassungseinheiten (402);
Durchführen des Verfahrens nach einem der vorstehenden Ansprüche, wobei
das Ermitteln eines lokalen Analysemodells das Auswählen von Parametern für ein Modell zum Umwandeln von Methansensorausgaben in eine Bewertung des Standortzustands basierend auf einer Datenbank (408) von Modellparametern und einer Genauigkeit von Ermittlungen von Änderungen des Standortzustands aufweist;
das Ermitteln eines Aktionsauslöserergebnisses das Ermitteln einer Änderung des Standortzustands basierend auf den Sensorausgaben und das Neubetrachten des Standorts durch das Modell basierend auf der Änderung des Standortzustands aufweist; und
das Aktualisieren der Datenbank lokaler Analyse- und Modellreaktionsergebnisse das Aktualisieren der Datenbank (408) von Modellparametern und der Genauigkeit von Ermittlungen von Änderungen des Standortzustands basierend auf dem Neubetrachten des Standorts aufweist.

**7.** Das Verfahren nach Anspruch 6, wobei das Auswählen von Parametern für ein Modell eine gewichtete Randomisierung basierend auf einer Überlappung von Konfidenzintervallen für die Genauigkeit der Ermittlungen von Änderungen des Standortzustands aufweist.

**8.** Das Verfahren nach einem vorstehenden Anspruch 6 bis Anspruch 7, wobei das Auswählen von Parametern für ein Modell gemäß einem zusammengefassten Kontrollexperiment-Design durchgeführt wird.

**9.** Das Verfahren nach einem vorstehenden Anspruch 6 bis Anspruch 8, wobei das Neubetrachten des Standorts ferner das Messen von Methanpegeln an dem Standort aufweist.

**10.** Das Verfahren nach einem vorstehenden Anspruch 6 bis Anspruch 9, wobei die Genauigkeit einer Ermittlung der Änderung des Standortzustands als Treffer, Fehlschlag, Fehlalarm oder korrekte Zurückweisung klassifiziert wird.

**11.** Ein System zum Verwenden eines Analysemodells, um eine Situation zu bewerten, aufweisend:

eine lokale Analysevorrichtung (300; 402), aufweisend: einen oder mehrere Sensoren (302; 402), einen Modellspeicher und einen lokalen Analyseprozessor (304), der konfiguriert ist, um die Ergebnisse des einen oder der mehreren Sensoren (302; 402) basierend auf einem in dem Modellspeicher gespeicherten Modell zu bewerten;
einen Modellermittlungsprozessor (308), der konfiguriert ist, um ein lokales Analysemodell zu ermitteln;
einen Speicher, der konfiguriert ist, um eine Datenbank (310; 408) von lokalen Analysemodellen und -ergebnissen zu speichern;
eine Reaktionsressource, die durch den lokalen Analyseprozessor ausgelöst wird;
**dadurch gekennzeichnet, dass** der Modellermittlungsprozessor (308) konfiguriert ist, um einen optimalen Beta-Wert für die lokale Analysevorrichtung (300; 402) unter Verwendung von Rauschverteilungen und Signal-plus-Rauschverteilungen zu ermitteln, die basierend auf Ergebnisdaten aktualisiert worden sind.

**12.** Das System nach Anspruch 11, wobei der Prozessor, der konfiguriert ist, um einen optimalen Beta-Wert zu ermitteln, konfiguriert ist, um

eine Rauschverteilung p(N) durch Berechnen einer Anzahl von Fehlalarmen und korrekten Zurückweisungen, geteilt durch eine Gesamtzahl von Ergebnissen, zu berechnen;
eine Signal-plus-Rauschverteilung p(SN) durch Berechnen von 1-p(N) zu ermitteln; und den optimalen Beta-Wert zu berechnen als

$$(p(N)/p(SN)) \times (V(CR)-C(FA))/(V(H)-C(M))$$

wobei V(CR) ein Wert einer korrekten Zurückweisung ist, C(FA) Kosten eines Fehlalarms sind, V(H) ein Wert eines Treffers ist und C(M) Kosten eines Fehlschlags sind.

**13.** Das System nach einem vorstehenden Anspruch 11 bis Anspruch 12, ferner aufweisend eine Schnittstelle zum Eingeben eines Ergebnisses einer Ermittlung durch den lokalen Analyseprozessor (304).

**14.** Das System nach einem vorstehenden Anspruch 11 bis Anspruch 13, wobei die Reaktionsressource einen Sensor (410) aufweist.

**15.** Das System nach einem vorstehenden Anspruch 11 bis Anspruch 14, wobei der Modellermittlungsprozessor (308), der konfiguriert ist, um ein lokales Analysemodell zu ermitteln, das lokale Analysemodell basierend auf einer gewichteten Randomisierung lokaler Analysemodelle basierend auf einer Überlappung zwischen Konfidenzintervallen für ihren Beta-Wert und den optimalen Beta-Wert ermittelt.

**Revendications**

**1.** Procédé pour mettre à jour un modèle analytique utilisé avec un dispositif, comprenant :

la détermination d'un modèle analytique local comprenant un déclencheur d'action, sur la base d'une base de données (310 ; 408) de modèles analytiques locaux et de résultats de réponse de modèle ;
la fourniture du modèle analytique local à un dispositif analytique local (300 ; 402, 410) ;
l'initiation d'une réponse lorsque des sorties de capteur au niveau du dispositif analytique local (300 ; 402, 410) respectent le déclencheur d'action ;
la détermination d'un résultat de déclencheur d'action sur la base de conditions au niveau du dispositif analytique local (300 ; 402, 410) mesurées pendant la réponse initiée ;
la mise à jour de la base de données (310 ; 408) de résultats d'analytiques locaux et de réponse de modèle avec le résultat de déclencheur d'action ; **caractérisé en ce qu'**il comprend en outre :
le calcul d'une valeur bêta optimale pour le dispositif analytique local (300 ; 402, 410) en utilisant des distributions de bruit et des distributions de signal plus bruit mises à jour sur la base de données de résultat.

**2.** Procédé selon la revendication 1, dans lequel le calcul de la valeur bêta optimale comprend :

la détermination d'une distribution de bruit p(N) en calculant un nombre de fausses alarmes et de rejets corrects divisé par un nombre total de résultats ;
la détermination d'une distribution de signal plus bruit p(SN) en calculant 1-p(N), et le calcul de la valeur bêta optimale en tant que

$$(p(N) \, / \, p(SN)) \times (V(CR)\text{-}C(FA))/(V(H)\text{-}C(M))$$

où V(CR) est une valeur d'un rejet correct, C(FA) est un coût d'une fausse alarme, V(H) est une valeur d'un succès, et C(M) est un coût d'un échec.

**3.** Procédé selon une quelconque revendication 1 à revendication 2 précédentes, dans lequel la détermination d'un modèle analytique local comprend une randomisation pondérée basée sur un chevauchement d'intervalles de confiance pour d-prime de chacun parmi une pluralité de modèles locaux, où d-prime désigne une valeur de sensibilité pour des capteurs.

**4.** Procédé selon une quelconque revendication 1 à revendication 3 précédentes, dans lequel la détermination du modèle analytique local comprend :

la sélection d'un ou plusieurs essais couplés ; et
l'association du ou des essais couplés au modèle analytique local déterminé.

**5.** Procédé selon la revendication 4, dans lequel la détermination du résultat de déclencheur d'action comprend :

la réception de données de résultat pour des essais couplés associés ; et

la comparaison des données de résultat pour des essais couplés associés au résultat de la réponse d'action.

6. Procédé pour évaluer un site de fuite de gaz, comprenant :

le déploiement d'une pluralité d'unités de détection de méthane à distance (402) sur un site (400) ;
la réception de sorties de capteur depuis la pluralité d'unités de détection de méthane à distance (402) ; la mise en oeuvre du procédé selon l'une quelconque des revendications précédentes, dans lequel
la détermination d'un modèle analytique local comprend la sélection de paramètres pour un modèle pour convertir des sorties de capteur de méthane en une évaluation de condition de site sur la base d'une base de données (408) de paramètres de modèle et de précision de déterminations de changements de condition de site ;
la détermination d'un résultat de déclencheur d'action comprend la détermination d'un changement de condition de site sur la base des sorties de capteur et la revisite du site par le modèle sur la base du changement de condition de site ; et
la mise à jour de la base de données de résultats d'analytiques locaux et de réponse de modèle comprend la mise à jour de la base de données (408) de paramètres de modèle et de précision de déterminations de changements de condition de site sur la base de la revisite du site.

7. Procédé selon la revendication 6, dans lequel la sélection de paramètres pour un modèle comprend une randomisation pondérée basée sur un chevauchement d'intervalles de confiance pour la précision de déterminations de changements de condition de site.

8. Procédé selon une quelconque revendication 6 à revendication 7 précédentes, dans lequel la sélection de paramètres pour un modèle est mise en œuvre selon une conception expérimentale témoin couplée.

9. Procédé selon une quelconque revendication 6 à revendication 8 précédentes, dans lequel la revisite du site comprend en outre la mesure de taux de méthane au niveau du site.

10. Procédé selon une quelconque revendication 6 à revendication 9 précédentes, dans lequel la précision d'une détermination de changement de condition de site est classée comme un succès, un échec, une fausse alarme ou un rejet correct.

11. Système pour utiliser un modèle analytique pour évaluer une situation, comprenant :

un dispositif analytique local (300 ; 402) comprenant un ou plusieurs capteurs (302 ; 402), une mémoire de modèle, et un processeur analytique local (304) configuré pour évaluer les sorties du ou des capteurs (302 ; 402) sur la base d'un modèle stocké dans la mémoire de modèle ;
un processeur de détermination de modèle (308) configuré pour déterminer un modèle analytique local ;
une mémoire configurée pour stocker une base de données (310 ; 408) de modèles analytiques locaux et de résultats ;
une ressource de réponse déclenchée par le processeur analytique local ;
**caractérisé en ce que** le processeur de détermination de modèle (308) est configuré pour déterminer une valeur bêta optimale pour le dispositif analytique local (300 ; 402) en utilisant des distributions de bruit et des distributions de signal plus bruit mises à jour sur la base de données de résultat.

12. Système selon la revendication 11, dans lequel le processeur configuré pour déterminer une valeur bêta optimale est configuré pour

déterminer une distribution de bruit p(N) en calculant un nombre de fausses alarmes et de rejets corrects divisé par un nombre total de résultats ;
déterminer une distribution de signal plus bruit p(SN) en calculant 1-p(N) ; et calculer la valeur bêta optimale en tant que

$$(p(N) \, / \, p(SN)) \times (V(CR)\text{-}C(FA))/(V(H)\text{-}C(M))$$

où V(CR) est une valeur d'un rejet correct, C(FA) est un coût d'une fausse alarme, V(H) est une valeur d'un succès, et C(M) est un coût d'un échec.

**13.** Système selon une quelconque revendication 11 à revendication 12 précédentes, comprenant en outre une interface pour entrer un résultat d'une détermination par le processeur analytique local (304).

**14.** Système selon une quelconque revendication 11 à revendication 13 précédentes, dans lequel la ressource de réponse comprend un capteur (410).

**15.** Système selon une quelconque revendication 11 à revendication 14 précédentes, dans lequel le processeur de détermination de modèle (308) configuré pour déterminer un modèle analytique local détermine le modèle analytique local sur la base d'une randomisation pondérée de modèles analytiques locaux basés sur un chevauchement entre des intervalles de confiance pour leur valeur bêta et la valeur bêta optimale.

Update Noise and Signal + Noise Distributions — 100

Select a Local Analytics Device or Devices — 102

Determine a Model for Evaluating Sensor Outputs at a Device — 104

Provide Model to Local Analytics Device or Devices — 106

Initiate a Response When Model Finds Satisfaction of an Action Trigger — 108

Take Triggered Action and Determine Outcome — 110

Update Database of Models and Action Trigger Outcomes — 112

FIG. 1

Update Noise and
Signal + Noise
Distributions — 200

Deploy Sensors to a
Location to Monitor
a Condition — 202

204 — Determine a
Threshold Value for
the Sensor
Deployment

Update Database of
Threshold Values
and Response
Outcomes — 210

Trigger a Response
when Sensor
Outputs meet
Threshold — 206

Determine Whether — 208
Response is Hit,
Miss, False Alarm or
Correct Rejection

*FIG. 2*

**300** Local Analytics Device

Sensors — 302

Model Memory — 306

Local Analytics Processor — 304

312 — Action Response

Outcome Determination & Logging — 314

308 — Model Determination Processor

Sensor Response & Outcome Database — 310

*FIG. 3*

*FIG. 4*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20150148919 A1
- WO 2016011007 A1
- US 20090113049 A1